# EUROPÄISCHE PATENTSCHRIFT

(11) **EP 1 166 358 B1**
(45) Veröffentlichungstag und Bekanntmachung des Hinweises auf die Patenterteilung: **14.03.2012**
(21) Anmeldenummer: 00925180.2
(22) Anmeldetag: 07.04.2000
(51) Int. Cl.: H01L 27/142, H01L 31/048, B23K 26/00, B23K 26/06

(54) **VERFAHREN ZUM ABTRAGEN VON DÜNNEN SCHICHTEN AUF EINEM TRÄGERMATERIAL**
METHOD FOR REMOVING THIN LAYERS ON A SUPPORT MATERIAL
PROCEDE PERMETTANT DE RETIRER DES COUCHES MINCES RECOUVRANT UN MATERIAU SUPPORT

(30) Priorität: 07.04.1999 DE 19915640; 16.06.1999 DE 19927529; 19.07.1999 DE 19933703
(43) Veröffentlichungstag der Anmeldung: 02.01.2002
(73) Patentinhaber: Saint-Gobain Glass France S.A., 92400 Courbevoie (FR)
(72) Erfinder: VOGT, Helmut, D-80807 München (DE); KARG, Franz, D-80689 München (DE)
(74) Vertreter: Lendvai, Tomas
(86) Internationale Anmeldenummer: PCT/EP2000/003132
(87) Internationale Veröffentlichungsnummer: WO 2000/060668

(56) Entgegenhaltungen:
- EP-A- 0 536 431
- WO-A1-99/03157
- DE-A- 3 705 500
- JP-A- 9 108 880
- US-A- 4 650 524
- US-A- 4 705 698
- US-A- 4 734 550
- US-A- 5 151 135
- US-A- 5 741 370
- PATENT ABSTRACTS OF JAPAN vol. 1998, no. 06, 30. April 1998 (1998-04-30) & JP 10 052780 A (MITSUBISHI HEAVY IND LTD), 24. Februar 1998 (1998-02-24)

## Beschreibung

Die Erfindung betrifft ein Verfahren zum Abtragen von dünnen Schichten auf einem Trägermaterial.

Die Erfindung ist auf das Abtragen von Randschichten einer Dünnschichtsolarzelle gerichtet. Darüber hinaus betrifft die Erfindung ein Verfahren zum Verkapseln eines Dünnschicht-Solarmoduls bestehend aus einem mit Dünnschichten beschichteten Substrat.

Herkömmliche Solarmodule aus kristallinem Silizium basieren auf einer Waferherstellung und einer nachfolgenden elektrischen Verdrahtung. Hieraus entstehen relative kleine Leistungseinheiten von ca. 1 W Silizium-Wafern, die dann in der Regel zu 50 - 100 W Modulen verschaltet werden müssen.

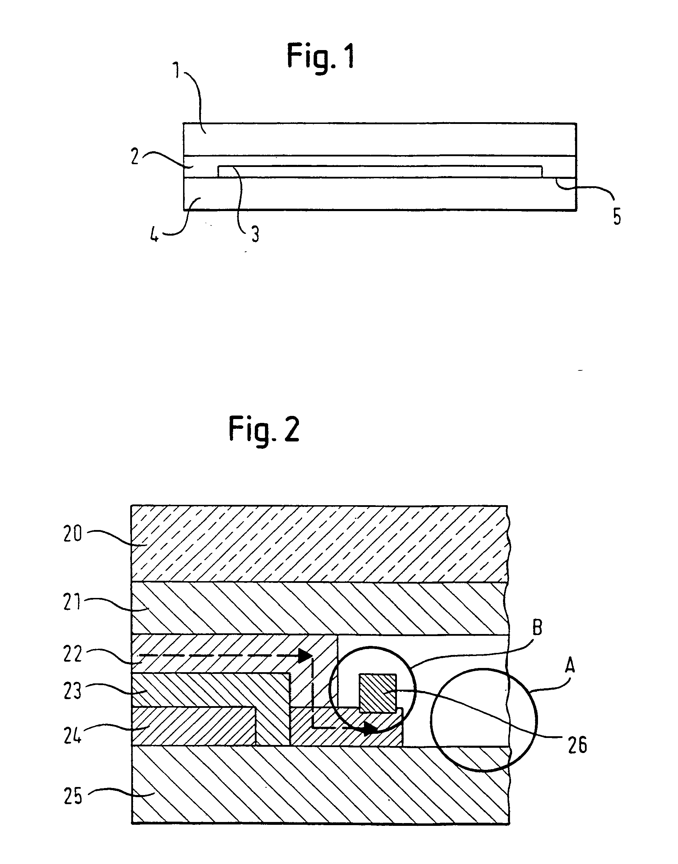

Als Alternative zu diesen herkömmlichen Solarmodulen sind Dünnfilmsolarzellen bekannt geworden, die auf Schichtdicken im Mikrometerbereich basieren. Die wesentlichen Elemente einer Dünnfilmsolarzelle sind in Fig. 2 gezeigt und bestehen aus einem p/n-Übergang zwischen der Absorberschicht und der Fensterschicht.

Im Unterschied zur herkömmlichen Verdrahtung von Silizium-Wafern können Dünnfilmzellen integriert verschaltet werden: im Anschluss an einzelne Beschichtungsschritte auf der Gesamtfläche werden a) die Rückelektrode b) die dazwischen liegende Zelle und c) die Frontelektrode in Längsstreifen unterteilt. Werden die drei Schnitte relativ zueinander seitlich versetzt, bildet sich eine elektrische Verbindung zwischen Front- und Rückelektrode benachbarter Zellen. Für die einzelnen Schnitte können mechanische Ritzverfahren oder Verfahren mit Lasern angewendet werden. Auf diese Weise kann kostengünstig ein Standard-Solarmodul für 12 V - Anwendungen hergestellt werden, das beispielsweise eine Ausdehnung von ca. 0,5 x 0,5 m² aufweist.

Die Lebensdauer eines derartigen Solarmoduls wird maßgeblich dadurch beeinflusst, wie gut die Dünnschichten vor Witterungs- und anderen Umwelteinflüssen geschützt sind. Um eine möglichst lange Lebensdauer von 30 Jahren und mehr zu erreichen, müssen die Dünnschichten den extremen Einwirkungen von Sonnenstrahlen, Feuchtigkeit und Luftschadstoffen dauerhaft standhalten. Die Anforderungen hinsichtlich Feuchtestabilität und Spannungsfestigkeit können daher nur erfüllt werden, wenn eine ausreichende Verkapselung der Dünnschicht-Solarzelle sowie eine ausreichende elektrische Isolation der stromführenden Komponenten gewährleistet ist. Hierzu werden die stromführenden Komponenten einer Dünnschicht-Solarzelle mit einem Laminat eingekapselt. Die Einkapselung wird dadurch erreicht, dass nach Beschichtung des Substrats mit den stromführenden Schichten der Randbereich des Substrats wieder entschichtet und eine Laminatschicht sodann über die gesamte Schicht aufgebracht wird. Hierdurch erreicht man im Randbereich eine korrosionsbeständige Verklebung von Laminatschicht und Substrat. Somit sind die inneren Bereiche zuverlässig gegen eine Feuchtedegration geschützt.

Fig. 1 zeigt zur Verdeutlichung eine schematische Darstellung eines Schnitts durch eine verkapselte Solarzelle. Auf dem Substrat 4 sind demnach strukturierte Schichten 3 aufgebracht, die in den Randbereichen 5 entschichtet und durch eine Laminatschicht 2 eingekapselt sind. Über der Laminatschicht 2 ist wiederum eine Schicht aus Fensterglas 1 aufgebracht.

Ein Problem bei einer derartigen Einkapselung einer Dünnschicht-Solarzelle ist die Entschichtung der Dünnschichten im Randbereich. Die herkömmlichen Entschichtungsverfahren, wie etwa die Sandstrahlbearbeitung oder die Entschichtung mit einer Schleifscheibe, führen unvermeidlich auch zu einer Beschädigung des Substratrandes und zur Bildung von Mikrorissen in diesem Bereich. Aufgrund der großen Temperaturunterschiede in einem sich in Betrieb befindlichen Dünnschicht-Modul und den daraus entstehenden Zugspannungen erhöht sich die Bruchgefahr, so dass Rissbildungen im Randbereich schließlich zu einer Beschadigung einer Solarzelle führen können. Die Randentschichtung muss also in dem üblicherweise einige Millimeter bis Zentimeter breiten Randbereich besonders schonend erfolgen.

Zur Bearbeitung von Solarzellen sind grundsätzlich chemische Abtragungsverfahren bekannt, die allerdings den Nachteil langer Prozesszeiten haben und aufwendige Prozessschritte nach sich ziehen.

Die Entfernung der beschriebenen Randbereiche erfolgt daher bislang weiter durch mechanische Verfahren wie Schleifen oder Sandstrahlen, da mit diesen Verfahren eine genaue Dosierung des Materialabtrages möglich ist. Neben der bereits unerwünschten Beschädigung des Substratrandes und der Bildung von Mikrorissen haben diese Verfahren außerdem den Nachteil, daß im Nachgang in der Regel eine chemische Reinigung des Werkstücks im Ultraschallbad erforderlich ist, da durch die Aufwirbelung der abgetragenen Schichten das Modul in unerwünschter Weise verschmutzt wird.

Es ist weiterhin bekannt, die oben beschriebenen Schritte zur integrierten Verschaltung eines Dünnschicht-Solarmoduls durch einen Laserstrahl herzustellen, um die sich hierdurch bildenden einzelnen Streifen dann seriell untereinander zu verschalten.

Beispielsweise ist aus US 4,734,550 ein Verfahren zur Bearbeitung von dünnen Schichten mit einem Laser bekannt. Als besondere Anwendung wird die Bearbeitung von mit der Dünnschichttechnik erzeugten photoelektrischen Schichten genannt. Das Bearbeitungsverfahren setzt sich zum Ziel, eine möglichst genaue Kerbe in die dünnen Schichten einzubringen. Hierzu wird der Bearbeitungsstrahl auf die Oberfläche des jeweiligen Werkstücks derart aufgebracht, dass die momentan gerade beaufschlagte Leistungsverteilung möglichst homogen bleibt. Dies wird durch einen rechteckig fokussierten Strahl mit flacher Intensitätsverteilung erreicht, wobei die Strahlführung zusätzlich derart gesteuert ist, dass die Überlappungsbereiche des rechteckig fokussierten Strahls in Bewegungsrichtung eine möglichst gleichmäßige Intensitätsverteilung ergeben. Mit diesem Verfahren sollen präzise und gleichmäßig tiefe Einkerbungen zur Serienverschaltung von Solarzellen hergestellt werden können.

Sämtliche Verfahren zur-Serienverschaltung von Solarzellen haben eine möglichst geringe Spurbreite zum Ziel, um die elektrische Leistung des Solarmoduls möglichst wenig zu beeinträchtigen. In der US 4,734,550 sind beispielsweise Spurbreiten im Bereich von 50 µm erwähnt.

In Ergänzung dazu sind in Nakano, 5., et al., "Laser Patterning Method for Integrated Type a-Si Solar Cell Submodules", In: Jap. J. of Appl. Phys. Vol. 25, No. 12, 1986, Seite 1936-1943, optimale Leistungsdichten angegeben, um Solarmodulen zur Serienverschaltung mit Laserstrahlen zu bearbeiten. Als geeignete Leistungedichten werden hier Leistungsdichten im Bereich von 1 · 10⁶ w/cm² bei einer Spurbreite von 50 µm genannt.

Da die Entschichtungsverfahren zur Serienverschaltung wie bereits erwähnt eine möglichst geringe Spurbreite zum Ziel haben, sind diese zur Randentschichtung von Solarmodulen ungeeignet, da für diese Anwendung Randstreifen im Bereich von einigen Millimetern entschichtet werden müssen. Deshalb werden zur Randentschichtung nach wie vor die oben erwähnten mechanischen Verfahren mit den ebenfalls erwähnten Nachteilen eingesetzt.

US 5 151 135 offenbart ein Verfahren zum Reinigen von chemischen, metallischen und Partikelverunreinigungen von festen Oberflächen. Die Methode umfasst die Bestrahlung der Oberfläche mit im wesentlichen ultravioletter Laserstrahlung, insbesondere von einem Excimer-Laser, wobei der Laserstrahl einen quadratischen Spot von 0.25 cm² haben kann, wobei ein optischer Homogenisator nach US 4,733,944 eingesetzt wird.

JP 10 052 780 A offenbart eine Vorrichtung zum Laserätzen. Ein Laserstrahl wird über eine Reihe von Spiegeln, Linsen und wenigstens einen Spalt, und einen weiteren Spalt oder eine Diffusorplatte auf dem Werkstück abgebildet.

Der Erfindung liegt die Aufgabe zugrunde, ein Verfahren zum Abtragen von Schichten einer Solarzelle bereitzustellen, um eine kostengünstige Abtragung von Streifen bis zu einigen Millimetern Breite

ohne Beschädigung des unter der abzutragenden Schicht liegenden Substrats zu ermöglichen.

Erfindungsgemäß wird diese Aufgabe nach der Lehre des Anspruchs 1 gelöst.

Weiterbildungen der Erfindung ergeben sich aus den diesem Anspruch nachgeordneten Ansprüchen.

Die Erfindung beruht auf der Erkenntnis, dass im Gegensatz zu bisher bekannten Anwendungen ein Laserabtragungsverfahren überraschenderweise auch für Abtragungsbreiten im Millimeterbereich verwendet werden kann. Gegenüber den Verfahren zur Serienverschaltung von Solarmodulen wird die Bearbeitungsfläche des Laserstrahls über ein geeignetes optisches System in einem Bereich von ca. 1 mm² bis zu 1 cm² (also um einige Größenordnungen mehr) ausgeweitet. Überraschenderweise hat sich dabei gezeigt, dass selbst bei einer derartig großen Ausweitung des Bearbeitungsstrahls noch eine zuverlässige Entschichtung von dünnen Schichten auf einem Trägermaterial möglich ist, wenn Lichtimpulse des Bearbeitungsstrahls mit Impulsdauern kleiner 100 ns und einer Impulsenergiedichte im Bereich von 0,1 J/cm² bis 10 J/cm² erzeugt werden. Vermutlich wurde bisher angenommen, dass bei einer derartigen Ausweitung des Bearbeitungsstrahls die ausgesendete Energie nicht mehr ausreichend absorbiert werden kann. Der Abtragungsprozess ist nämlich auch bei den verwendeten Spurbreiten für die Serienverschaltung nicht vollständig geklärt. Vermutlich erzeugen die Lichtimpulse in den obersten Mikrometern der Dünnschicht ein Plasma, dessen Ausdehnung eine Stosswelle nach sich zieht. Der erhitzte Werkstoff steht somit unter einem hohen Innendruck, so dass die Plasmaartikel aus dem bestrahlten Bereich herausgeschleudert werden. Hierbei konnte nicht erwartet werden, dass bei einer Ausweitung des Bearbeitungsstrahls um mehrere Größenordnungen sich ähnlich gute Effekte noch erzielen lassen, wenn die übrigen Randparameter in geeigneten Bereichen ausgewählt werden. Entscheidend ist darüber hinaus, dass der Bearbeitungsstrahl mit einer im wesentlichen homogenen Leistungsverteilung abgebildet wird. Üblicherweise kann bei dem Bearbeitungsstrahl eine gaußförmige Leistungsverteilung angenommen werden, allerdings lehrt die Erfindung, dass das optische System derart ausgebildet sein muss, dass sich in weiten Bereichen über die Bearbeitungsfläche eine homogene Leistungsverteilung ergibt. Ansonsten konnten bei der erfindungsgemäßen Ausweitung des Bearbeitungsstrahls keine zufriedenstellenden Abtragungsergebnisse erzielt werden.

Um die erfindungsgemäßen Abtragungsergebnisse zu erzielen, besteht eine weitere Erkenntnis der Erfindung schließlich darin, dass der Bearbeitungsstrahl gegenüber dem Werkstück derart bewegt wird, dass jede abzutragende Flächeneinheit des Werkstücks mit einer im wesentlichen konstanten Energiemenge beaufschlagt wird.

Mit der verwendeten Vorrichtung ist es insbesondere möglich, ein Dünnschicht-Solarmodul bestehend aus einem mit Dünnschichten beschichteten Substrat auf wirtschaftliche Weise zu verkapseln. Das Substrat ist hierbei also zunächst ganzflächig mit Dünnschichten im Bereich von einigen µm beschichtet. Mit der verwendeten Vorrichtung kann sodann in einem ersten Schritt das Substrat in den Randbereichen wirkungsvoll entschichtet werden. Die erste Stellvorrichtung kann dabei derart angesteuert werden, dass der Bearbeitungsstrahl auf dem Trägermaterial in einer Hin- und Herbewegung parallele, sich leicht überdeckende Schichtstreifen abträgt. In der Regel wird nämlich die Querschnittsbreite des Bearbeitungsstrahls immer noch geringer sein als die Breite des tatsächlich abzutragenden Bereichs, so dass durch eine derartige Ansteuerung der ersten Stellvorrichtung auf effektive Weise auch Randschichten mit einigen Zentimetern Breite abgetragen werden können. Neben einer Hin- und Herbewegung des Bearbeitungsstrahls bietet sich auch eine quasi-rotierende Bewegung an, durch die parallele, sich leicht überdeckende Schichtstreifen abgetragen werden. Bei einem rechteckigen oder quadratischen Dünnschicht-Solarmodul ist es beispielsweise denkbar, dass der Bearbeitungsstrahl in einem Umlauf jeweils einen Schichtstreifen im Bereich der Querschnittsbreite des Bearbeitungsstrahls abträgt. Auf diese Weise ist eine Entschichtung größerer Bereiche möglich, ohne dass die erste Stellvorrichtung abrupte Geschwindigkeitsänderungen durchführen muss.

Soweit das Substrat bei Dünnschicht-Solarzellen aus einem hinsichtlich des Bearbeitungsstrahls lichtdurchlässigen Material besteht, hat sich herausgestellt, dass eine Entschichtung nicht nur von der Schichtseite, sondern besonders vorteilhaft auch von der Substratseite her möglich ist. Mitunter lässt sich das Substrat auf diese Weise noch schonender entschichten, allerdings muss hierfür gegebenenfalls ein spezieller Werkzeugtisch mit geeigneten Ausschnitten vorgesehen werden, um alle gewünschten Bereiche entschichten zu können.

Bei Dünnschicht-Solarmodulen hat sich als weitere Anwendung schließlich eine partielle Entschichtung der strukturierten Schichten herausgestellt. Die strukturierten Schichten bestehen üblicherweise aus einer Frontelektrode, einer Absorberschicht und einer Rückelektrode, wobei die Rückelektrode zur Kontaktierung in bestimmten Bereichen freigelegt werden muss. Nach Freilegen der Rückelektrode kann diese dann durch Metallbänder kontaktiert werden. Da in diesem Fall das Substrat nicht komplett entschichtet werden darf, entfällt hier die Möglichkeit der Bearbeitung von der Substratseite, so dass hier immer von der Schichtseite her entschichtet werden muss.

Nach einer besonderen Ausführungsform ist hierbei vorgesehen, dass eine zweite Stellvorrichtung zum Einstellen eines konstanten Bearbeitungswinkels zwischen der optischen Achse des Bearbeitungsstrahls und dem Lot jeder abzutragenden Flächeneinheit vorgesehen ist. In aufwendigen Versuchsreihen hat sich herausgestellt, dass die Einstellung des Bearbeitungswinkels bei der Entschichtung eines Dünnschicht-Solarmoduls zwei Effekte haben kann: Zum einen kann durch die Einstellung des Bearbeitungswinkels erreicht werden, dass die Abtragungsgeschwindigkeit bzw. die Abtragungseffektivität optimiert wird. Soweit das Substrat mit mehreren Schichten beschichtet ist, kann darüber hinaus durch die Einstellung des Bearbeitungswinkels eine gewisse Selektivität der abzutragenden Schichten erreicht werden. Insbesondere konnte bei einem Dünnschichtaufbau gemäß Fig. 2 in bisher noch nicht vollständig geklärter Weise ein Bearbeitungswinkel gefunden werden, bei dem die Schicht der Frontelektrode und die Absorberschicht abgetragen werden konnten, während die Rückelektrode unbeschädigt blieb.

Um die aus Versuchsreihen ermittelten Bearbeitungswinkel reproduzierbar einstellen zu können, ist nach einer bevorzugten Ausführungsform vorgesehen, dass die zweite Stellvorrichtung durch die Steuereinheit ebenfalls ansteuerbar ist. Insbesondere kann vorgesehen sein, dass die Steuereinheit eine Speichereinheit und eine Eingabeeinheit aufweist, wobei in der Speichereinheit für jeden Typ des Entschichtungsprozesses ein optimaler Bearbeitungswinkel gespeichert ist und wobei bei Eingabe eines Typs eines Entschichtungsprozesses in die Eingabeeinheit die entsprechenden Steuersignale für einen optimalen Bearbeitungswinkel von der Steuereinheit an die zweite Stellvorrichtung weitergeleitet werden.

Bei der Freilegung einer Rückelektrode einer Dünnschicht-Solarzelle hat sich herausgestellt, dass vorzugsweise ein Winkel größer als 0°, insbesondere zwischen 5° und 10°, gewählt werden muss. Vermutlich führt die Schrägstellung der optischen Achse zum Einfallslot dazu, dass die unter der abzutragenden Schicht liegenden Schichten weniger zur Absorption der Laserstrahlen neigen, so dass diese Schichten völlig beschädigungsfrei bleiben.

Zur vollständigen Abtragung aller Schichten hat sich herausgestellt, dass insbesondere bei einer geeigneten Polarisation des Bearbeitungsstrahls als optimaler Bearbeitungswinkel der sogenannte Brewstersche Winkel gewählt werden kann, dessen Tangens gleich der Brechzahl der abzutragenden Schicht entspricht.

Nach einer bevorzugten Ausführungsform ist vorgesehen, dass die Lichtimpulse durch Modulation der Anregungsleistung erzeugt werden. Durch die Modulation der Anregungsleistung für das aktive Medium beim Laser lassen sich die erfindungsgemäßen Bearbeitungsparameter mit Impulsdauern knapp unter 100 ns auf kostengünstige Weise noch bereitstellen. Kürzere Lichtimpulse und höhere Leistungen lassen sich allerdings mit der Methode der Gütemodulation erreichen. Auf diese Weise können Lichtimpulse im Bereich von 10 ns mit ausreichender Leistung bereitgestellt werden. Für einige Anwendungen haben sich Impulsdauern im Bereich von 25 ns auch als besonders vorteilhaft erwiesen. Zur Realisierung noch kürzerer Impulszeiten kann schließlich auf das Verfahren der sogenannten Modenkopplung zurückgegriffen werden.

Erfindungsgemäß ist vorgesehen, dass der Bearbeitungsstrahl zur Modenmischung über eine Lichtleiterfaser geleitet wird, so dass sich als Leistungsverteilung ein annähernd kegelstumpfförmiges Leistungsprofil ergibt. Durch die Modenmischung in der Lichtleiterfaser wird das an sich bekannte gaußförmige Leistungsprofil in ein trapezförmiges bzw. räumlich gesehen kegelstumpfförmiges Leistungsprofil überführt.

Nach einer weiteren bevorzugten Ausführungsform ist vorgesehen, dass die Vorschubgeschwindigkeit der Relativbewegung und die Impulswiederholrate der Lichtimpulse derart abgestimmt sind, dass eine Flächeneinheit nicht mehr mit dem Bearbeitungsstrahl beaufschlagt wird, sobald die abzutragende Schicht entfernt ist. Beispielsweise kann die erste Stellvorrichtung derart angesteuert werden, dass sich bei der Relativbewegung eine Verfahrgeschwindigkeit im Bereich von 1 cm/s ergibt und dabei die Impulsfolgenfrequenz des Laserresonators im Bereich von 50 Hz liegt.

Als besonders vorteilhaft hat es sich herausgestellt, dass eine Flächeneinheit im wesentlichen nur mit einem oder zumindest nur mit einigen wenigen Lichtimpulsen beaufschlagt wird. Das abzutragende Material einer Flächeneinheit sollte also im wesentlichen mit einem Lichtimpuls "herausgesprengt" werden, damit das darunterliegende Substrat möglichst wenig beschädigt wird.

Die Wellenlänge des Laserresonators muss auf die abzutragende Schicht derart abgestimmt sein, dass die Lichtimpulse von der abzutragenden Schicht im wesentlichen absorbiert und von dem Trägermaterial nicht absorbiert werden. Bei der Entschichtung von Dünnschicht-Solarzellen hat sich beispielsweise ein Laserresonator vom Typ Nd:YAG mit einer Wellenlänge 1,064 µm bewährt.

Nach einer weiteren bevorzugten Ausführungsform ist eine Absaugvorrichtung zur Absaugung der entstehenden Stäube und Dämpfe vorgesehen. Auf diese Weise ist zum einen der Schutz des Bedienpersonals vor den entstehenden Dämpfen und Stäuben gewährleistet, zum anderen können dadurch auch Niederschläge auf dem Werkstück vermieden werden, die die Oberflächenqualität der freizulegenden Schicht beeinträchtigen könnten.

Nach einer bevorzugten Ausführungsform ist vorgesehen, dass die erste Stellvorrichtung aus einer mechanischen Führung besteht, mit der der Bearbeitungsstrahl samt dem optischen System über das Werkstück geführt wird. In diesem Fall bleibt also das Werkstück ortsfest, während die optische Einrichtung beweglich geführt ist. Hierzu wird der Bearbeitungsstrahl über eine Lichtleiterfaser geführt. Es ist nützlich für das Verständnis der Erfindung, dass es auch denkbart ist, dass die erste Stellvorrichtung aus verstellbaren Umlenkspiegeln besteht, über die der Bearbeitungsstrahl auf dem Werkstück geführt wird. Als Umlenkspiegel können beispielsweise zwei Umlenkspiegel mit senkrecht zueinander liegenden Drehachsen verwendet werden, so dass der Bearbeitungsstrahl einfach über eine größere Ebene bewegt werden kann. Darüber hinaus ist es auch möglich, dass das optische System ortsfest gehaltert ist, während das Werkstück, beispielsweise auf einem xy-Tisch, gegenüber dem feststehenden Bearbeitungsstrahl geführt wird. Schließlich sind auch Kombinationen der oben genannten Prinzipien denkbar, bei denen sowohl der Bearbeitungsstrahl als auch das Werkstück beweglich geführt sind.

Neben der Verwendung zur Entschichtung von Dünnschicht-Solarzellen kann die verwendete Vorrichtung selbstverständlich zur Entschichtung sämtlicher Gläser oder Keramiken verwendet werden, die mit einer Dünnschicht beschichtet sind. Weitere Anwendungen könnten demnach sein:
- Heutige Isoliergläser für Fensterscheiben, sogenannte "K-Gläser", weisen zusätzlich aufgedampfte Schichten auf, um die Durchlässigkeit der Fensterscheiben gegenüber Wärmestrahlung zu verringern. Typische Isoliergläser bestehen aus mindestens zwei Einzelscheiben, die mit einem Rahmenprofil zu einer Doppelglasscheibe verklebt werden, so dass auch hier eine Randentschichtung erforderlich ist.
- In der gesamten Displaytechnik fallen ebenfalls vielfältig Entschichtungsprozesse an.
- Schließlich kommen weitere Anwendungen in Betracht, bei denen beschichtete Gläser weiterverarbeitet werden müssen. Ein mögliches Beispiel sind sogenannte "schaltbare Fenster", die bei Anlegen eines elektrischen Feldes ihre Lichtdurchlässigkeit ändern.

Im folgenden wird die Erfindung anhand verschiedener Ausführungsbeispiele mit Bezug auf die beiliegenden Zeichnungen näher erläutert. Es zeigen:
- Fig. 1: einen Querschnitt durch eine verkapselte Dünnschichtsolarzelle,
- Fig. 2: einen Querschnitt durch eine verkapselte Dünnschichtsolarzelle mit Schichtfolge und Kontaktierung der Rückelektrode,
- Fig. 3: eine erste Vorrichtung zur Entschichtung von Solarzellen und
- Fig. 4: eine zweite Vorrichtung zur Entschichtung von Solarzellen.

Fig. 1 zeigt einen Querschnitt durch eine verkapselte Dünnschichtsolarzelle. Die Solarzelle besteht im wesentlichen aus einem Substrat 4, den darauf aufgebrachten und strukturierten Schichten 3, einer Laminatschicht 2 und einer darauf aufgebrachten Schicht Fensterglas. Die stromführenden Schichten 3 weisen eine Dicke von 0,1 - 5 µm auf und das Substrat 4 besteht vorzugsweise aus Floatglas. Um Strompfade zu den stromführenden Schichten 3 und eine Feuchtedegration der Schichten selbst zu vermeiden, darf der Randbereich 5 des Substrats 4 keine stromführenden Schichten enthalten. Der Randbereich 5 ist deshalb erfindungsgemäß entschichtet worden.

Fig. 2 zeigt einen Querschnitt durch eine verkapselte Dünnschichtsolarzelle mit Schichtfolge und Kontaktierung der Rückelektrode. Bei Substrat-Dünnschichtsolarzellen gliedert sich die Schichtfolge auf in die Rückelektrode 24, die Absorberschicht 23 und die Frontelektrode 22. Die Schichten sind auf dem Substrat 25 aufgebracht und seitens der Frontelektrode 22 durch das Laminat 21 geschützt. Das Laminat 21 wird durch eine Schicht 20 aus Fensterglas abgeschlossen.

In Fig. 2 sind zwei Bereiche A und B markiert, die die verschiedenen Ergebnisse möglicher Entschichtungsprozesse bei einer Dünnschicht-Solarzelle darstellen.

In dem Bereich A wurde eine komplette Entschichtung des Substrats vorgenommen, wobei das Substrat selber mit einer beschädigungsfreien Oberfläche zurückbleibt. Im Bereich B wurde eine selektive Entschichtung der Frontelektrode und der Absorberschicht vorgenommen, so dass die Rückelektrode stehen bleibt. Zur Kontaktierung der Rückelektrode müssen die darüberliegenden Schichten selektiv entfernt werden, ohne die Rückelektrode selbst wesentlich zu schädigen. Die freigelegten Bereiche werden dann mit Metallbändern 26 kontaktiert.

Bei der Entfernung der Schichten über den zu kontaktierenden Bereichen muss der Lichteinfall auf jeden Fall seitens der Schichtseite der Frontelektrode 22 erfolgen.

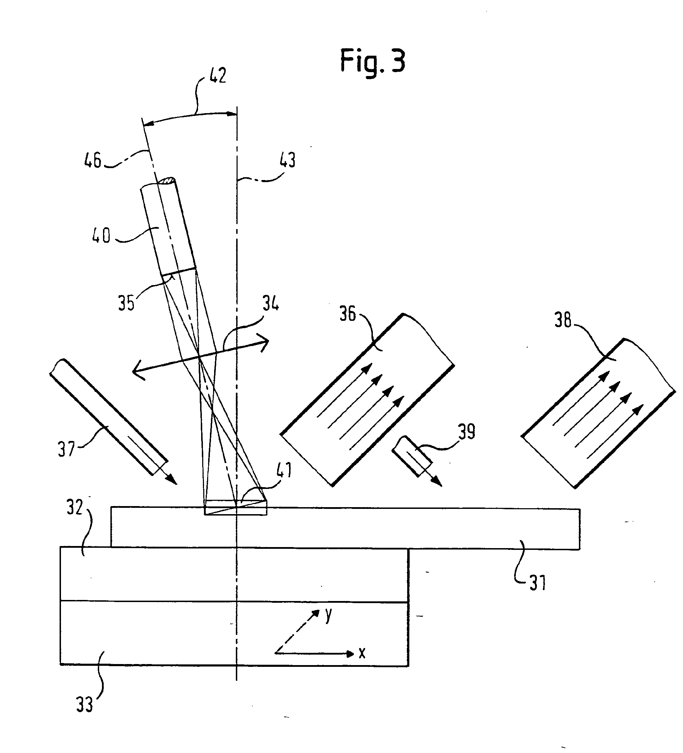

Für die Beurteilung der Qualität des Entschichtungsprozesses wurden auf die freigelegten Rückelektrodenbereiche Metallbänder mit einem zur Zeit eingesetzten Standardkontaktierprozess aufgebracht. Die gute Haftung der Bänder zeigt, dass die erfindungsgemäße Entschichtung mit einer Laservorrichtung auch zur Freilegung der zu kontaktierenden Bereiche der Rückelektrode geeignet ist. Die mechanische Entschichtung kann damit auch bei der Rückelektrodenfreilegung ersetzt werden. Fig. 3 zeigt eine erste Vorrichtung zur Entschichtung von Solarzellen. Die Entschichtung erfolgt mit einem gepulsten Laser vom Typ Nd:YAG. Vorzugsweise wird der Laserresonator mit der Methode der Gütemodulation mit Impulsdauern im Bereich von 25 ns betrieben. Der Bearbeitungsstrahl wird mit Hilfe eines Lichtleiterkabels 40 zu einer Abbildungsoptik mit einer Fokussierlinse 34 geleitet. Der Ausgang 35 der Lichtleiterfaser 40 wird dabei über die Fokussierlinse 34 auf dem Werkstück 31 im Bearbeitungsbereich 41 abgebildet.

Die Impulsenergiedichte auf dem Werkstück ergibt sich bei diesem Aufbau aus der Impulsenergie des Lasers, den optischen Verlusten sowie dem Abbildungsmaßstab der eingesetzten Optik. Die notwendige Impulsenergiedichte sowie die Verfahrgeschwindigkeit des Laserstrahls relativ zum zu entschichtenden Werkstück bei vorgegebener Impulsfrequenz sind abhängig vom zu entfernenden Schichtpacket. Zum Beispiel konnten die untersuchten Schichtpackete von Dünnschichtsolarmodulen mit Impulsenergiedichten in der Größenordnung von 1 J/cm² bei Verfahrgeschwindigkeiten in der Größenordnung von 1 cm/s und einer Impulsfrequenz von 50 Hz entfernt werden.

Bei der Entschichtung der Rückelektrode gemäß Fig. 2 ist die notwendige Impulsenergiedichte sowie die Verfahrgeschwindigkeit des Laserstrahls relativ zum zu entschichtenden Werkstück bei vorgegebener-Impulsfrequenz ebenfalls abhängig vom Schichtpacket. Eine erfolgreiche Entschichtung der Rückelektrode von Dünnschichtsolarmodulen wurde beispielsweise mit Pulsenergiedichten in der Größenordnung von 1 J/cm² bei Verfahrgeschwindigkeiten in der Größenordnung von 3 cm/s und einer Pulsfrequenz von 50 Hz erzielt.

Wie in Fig. 3 dargestellt, wird das Werkstück 31 dabei durch einen entsprechenden Werkzeugträger 32, bei dem es sich zum Beispiel um einen Vakuumspanntisch handeln kann, gehalten. Der Werkzeugträger 32 ist wiederum auf einem CNC-gesteuerten xy-Tisch 33 montiert. Der Tisch 33 mit dem Werkzeugträger 32 und dem Werkstück 31 kann mit konstanter Geschwindigkeit verfahren werden, so dass der Bearbeitungsbereich 41 zur Entschichtung der Solarzelle 31 entlang einer definierten Strecke bewegt werden kann. Entstehende Dämpfe und Stäube werden über Absaugvorrichtungen 36, 38 abgesaugt. Für besondere Anwendungsfälle sind Düsen 37, 39 vorgesehen, um die freizulegende Oberfläche vor Oxidation oder anderen chemischen Prozessen mit der Atmosphäre zu schützen. Als geeignetes Schutzgas hat sich hier vor allem Stickstoff herausgestellt. Die Düsen 37, 39 sind so eingestellt, dass im Bearbeitungsbereich das Schutzgas gleichmäßig über die Oberfläche des Werkstücks strömt.

Optimale Bearbeitungsergebnisse ergeben sich, wenn die optische Achse 46 der Abbildungsoptik gegenüber dem Einfallslot 43 auf einen für den jeweiligen Anwendungsfall zu bestimmenden optimalen Bearbeitungswinkel eingestellt wird. Im Fall der Freilegung einer Rückelektrode einer Dünnschichtsolarzelle haben sich beispielsweise Verkippwinkel im Bereich von 5° - 10° als besonders günstig herausgestellt.

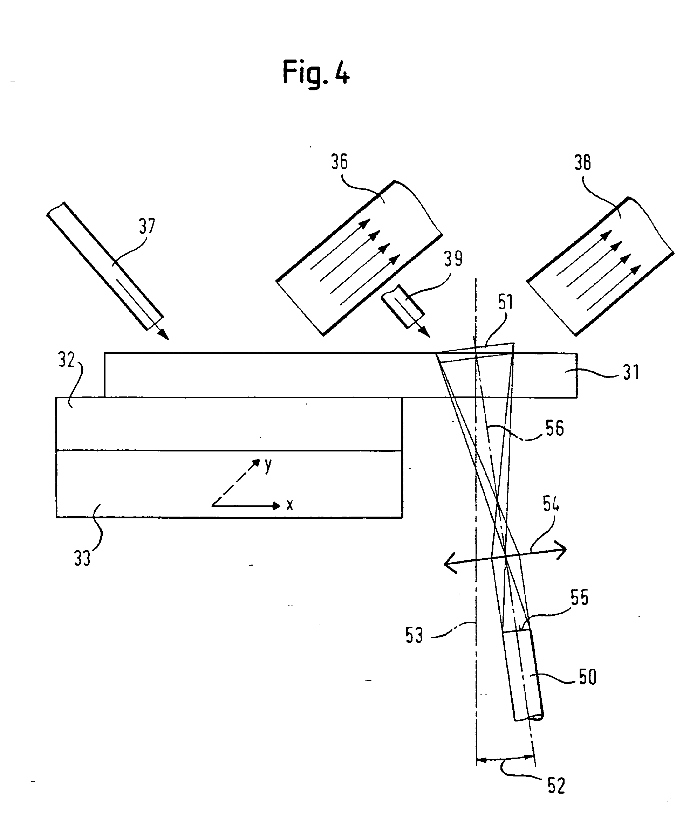

Fig. 4 zeigt eine zweite Vorrichtung zur Entschichtung von Solarzellen. Der Aufbau zur Halterung der Solarzelle 31 wurde gegenuber dem ersten Ausführungsbeispiel beibehalten und ist mit den gleichen Bezugszeichen gekennzeichnet. Ein wesentlicher Unterschied der zweiten Vorrichtung gemäß Fig. 4 zur ersten Vorrichtung besteht darin, dass die Entschichtung gemäß Fig. 4 im Bereich von der unteren Substratschicht erfolgt.

Diese Anwendung kommt bei allen Entschichtungsprozessen von Solarzellen in Betracht, bei denen ein lichtdurchlässiges Substrat vorliegt und das Substrat in bestimmten Bereichen völlig freigelegt werden soll. Während bei einem Einfall von der Schichtseite feine Haarrisse im Entschichtungsbereich entstanden, konnte das Glassubstrat bei Lichteinfall von der Substratseite entschichtet werden, ohne dass eine Schädigung des Substrats im Lichtmikroskop zu erkennen war.

Der optische Aufbau gleicht ansonsten demjenigen gemäß der ersten Vorrichtung, so dass entsprechend ebenfalls der Bearbeitungsstrahl mit einem Lichtleiter 50 an eine Abbildungsoptik mit einer Fokussierlinse 54 herangeführt wird. Die Fokussierlinse bildet wiederum den Austrittsbereich 55 des Lichtleiters 50 auf das Werkstück 31 im Bearbeitungsbereich 51 ab.

Bei der Entschichtungsmethode gemäß der zweiten Ausführungsform wurden beispielsweise gute Ergebnisse erzielt, wenn der Bearbeitungswinkel der optischen Achse 56 auf das Einfallslot eingestellt war.

Die beim Laserprozess erzeugten Stäube und Dämpfe werden auch bei der zweiten Ausführungsform abgesaugt. Eine Nachreinigung wie bei den bisher eingesetzten Entschichtungsverfahren ist weder für die Variante von der Substratseite noch für die Variante von der Schichtseite erforderlich. Damit sind beide Varianten des neuen Laserentschichtungsverfahrens den bisherigen mechanischen Verfahren vorzuziehen.

Besonders zu beachten ist bei der zweiten Ausführungsform gemäß Fig. 4 allerdings, dass für eine vollständige Bearbeitung der Solarzelle von der Substratseite her womöglich entsprechende Ausschnitte in dem xy-Tisch 33 und dem Werkzeugträger 32 vorgesehen sein müssen, damit der Bearbeitungsstrahl ungehindert alle zu entschichtenden Bereiche der Solarzelle 31 erreichen kann.

Insbesondere für Produkte, bei denen auch feinste Mikrorisse im Substrat bedenklich erscheinen, sollte daher die Variante mit Lichteinfall von der Substratseite eingesetzt werden. Bei weniger kritischen Anwendungen bzgl. Mikrorissen im Substrat - oder bei anderen Substrattypen - ist die hinsichtlich der Werkstückhalterung einfachere Entschichtung mit Lichteinfall von der Schichtseite möglich. Besonders vorteilhaft ist es auch, wenn die Verfahren gemäß den Ausführungsformen in geeigneter Weise kombiniert werden. So können zum Beispiel für den Bruch empfindliche Randbereiche des Substrats gemäß der zweiten Ausführungsform von der Substratseite her entschichtet werden, da diese Randbereiche auch für diesen Fall einfach zugänglich sind und somit entsprechende Ausschnitte in dem Werkzeugträger und in dem Spanntisch nicht benötigt werden. Für Spezialanwendungen zu entschichtende Mittenbereiche können dagegen wiederum gemäß der ersten Ausführungsform von der Schichtseite entschichtet werden.

## Patentansprüche

1. Verfahren zum Abtragen von dünnen Schichten auf einem Trägermaterial eines Werkstücks (31), nämlich zum Abtragen von Randschichten einer Dünnschichtsolarzelle als Werkstück, mit den Schritten:
Erzeugen eines aus Lichtimpulsen bestehenden Bearbeitungsstrahls mit Impulsdauern kleiner 100 ns und einer Impulsenergiedichte im Bereich von 0,1 J/cm² bis 10 J/cm²,
Leiten des Bearbeitungsstrahls zur Modenmischung über eine Lichtleiterfaser (34, 54), so dass sich als Leistungsverteilung ein annähernd kegelstumpfförmiges Leistungsprofil ergibt, und Abbilden des Bearbeitungsstrahls auf der zu bearbeitenden Oberfläche des Werkstücks (31) über eine Fläche (41, 51) im Bereich von einem mm² bis zu einem cm² mit einer im Wesentlichen homogenen Leistungsverteilung,
Ausführen einer Relativbewegung zwischen dem Werkstück (31) und dem Bearbeitungsstrahl derart, dass jede abzutragende Flächeneinheit des Werkstücks (31) mit einer im Wesentlichen konstanten Energiemenge beaufschlagt wird.

2. Verfahren nach Anspruch 1, bei welchem die Lichtimpulse durch Modulation der Anregungsleistung erzeugt werden.

3. Verfahren nach Anspruch 1, bei welchem die Lichtimpulse mit der Methode der Gütemodulation erzeugt werden.

4. Verfahren nach einem der Ansprüche 1-3, bei welchem die Lichtimpulse Impulsdauern im Bereich von 25 ns aufweisen.

5. Verfahren nach einem der Ansprüche 1 - 4, bei welchem die Vorschubgeschwindigkeit der Relativbewegung und die Impulswiederholrate der Lichtimpulse derart aufeinander abgestimmt sind, dass eine Flächeneinheit nicht mehr mit dem Bearbeitungsstrahl beaufschlagt wird, sobald die abzutragende Schicht entfernt ist.

6. Verfahren nach Anspruch 5, bei welchem die erste Stellvorrichtung mit einer Verfahrgeschwindigkeit im Bereich von 1 cm/s verschoben wird und dabei die Impulsfolgenfrequenz des Laserresonators im Bereich von 50 Hz liegt.

7. Verfahren nach Anspruch 5 oder 6, bei welchem eine Flächeneinheit im Wesentlichen mit einem Lichtimpuls oder mit einigen wenigen Lichtimpulsen beaufschlagt wird.

8. Verfahren nach einem der Ansprüche 1 - 7, bei welchem die Wellenlänge des Laserresonators auf die abzutragende Schicht derart abgestimmt ist, dass die Lichtimpulse von der abzutragenden Schicht im Wesentlichen absorbiert und von dem Trägermaterial nicht absorbiert werden.

9. Verfahren nach Anspruch 8, bei welchem der Laserresonator vom Typ Nd:YAG mit einer Wellenlänge 1,064 µm ist.

10. Verfahren nach einem der Ansprüche 1 - 9, bei welchem ein konstanter Bearbeitungswinkel zwischen der optischen Achse des Bearbeitungsstrahls und dem Lot (43, 53) jeder abzutragenden Flächeneinheit eingestellt wird.

11. Verfahren nach einem der Ansprüche 1 - 10, wobei ein Dünnschicht-Solarmodul bestehend aus einem mit Dünnschichten beschichteten Substrat verkapselt wird, wobei zunächst das Substrat in den Randbereichen in einem Verfahren nach einem der Ansprüche 1 bis 10 entschichtet wird und bei dem sodann das gesamte Substrat auf der Dünnschichtseite mit einer Laminatschicht derart überzogen wird, dass die Dünnschichten durch das Substrat und die Laminatschicht verkapselt sind.

## Claims

1. Method for removing thin layers on a substrate of a workpiece (31), especially for removing edge layers of a thin-film solar cell as workpiece, with the steps:
Generating a machining beam consisting of light pulses with pulse durations less than 100 ns and a pulse energy density in the range from 0.1 J/cm² to 10 J/cm²,
Guiding the machining beam for mode mixing via an optical fiber (34, 54), such that, as power distribution, a nearly truncated-cone-shaped power profile results, and imaging the machining beam on the surface of the workpiece (31) to be machined over an area (41, 51) in the range from one mm² to one cm² with substantially homogeneous power distribution,
Execution of a relative movement between the workpiece (31) and the machining beam such that each surface area of the workplace (31) to be removed is impacted with a substantially constant amount of energy.

2. Method according to claim 1, wherein the light pulses are generated by modulation of the excitation power.

3. Method according to claim 1, wherein the light pulses are generated by the method of Q-switching.

4. Method according to one of claims 1 through 3, wherein the light pulses have pulse durations of roughly 25 ns.

5. Method according to one of claims 1 through 4, wherein the advancing speed of the relative movement and the pulse repetition rate of the light pulses are adapted to each other such that a surface area unit is no longer impacted by the machining beam once the layer to be removed is removed.

6. Method according to claim 5, wherein the first positioning device is advanced at a speed of roughly 1 cm/s, and the pulse repetition rate of the laser resonator is approximately 50 Hz.

7. Method according to claim 5 or 6, wherein a surface area unit is impacted substantially by one light pulse or by a few light pulses.

8. Method according to one of claims 1 through 7, wherein the wavelength of the laser resonator is adapted to the layer to be removed such that the light pulses are substantially absorbed by the layer to be removed and are not absorbed by the substrate.

9. Method according to claim 8, wherein the laser resonator is of the type ND:YAG with a wavelength of 1.064 µm.

10. Method according to one of claims 1 through 9, wherein a constant machining angle is set between the optical axis of the machining beam and the perpendicular (43, 53) to each surface area unit to be removed.

11. Method according to one of claims 1 through 10, wherein a thin-film solar module made of a substrate coated with thin layers is encapsulated, wherein, first, the substrate is coated in the edge regions in a method according to one of claims 1 through 10 and in which, then, the entire substrate is covered on the thin-film side with a laminate layer such that the thin film layers are encapsulated by the substrate and the laminate layer.

## Revendications

1. Procédé pour enlever des couches minces d'un matériau de support d'une pièce (31), à savoir pour enlever des couches marginales d'une pièce consistant en une cellule solaire à couches minces, comprenant les étapes consistant à :
produire un faisceau d'usinage composé d'impulsions lumineuses, avec des durées d'impulsion inférieures à 100 ns et une densité d'énergie d'impulsion se situant dans la plage de 0,1 J/cm² à 10 J/cm² ;
envoyer le faisceau d'usinage, pour réaliser un mélange de modes, dans une fibre de guide de lumière (34, 54), de telle sorte que l'on obtienne comme distribution de la puissance un profil de puissance de forme approximativement tronconique, et reproduire le faisceau d'usinage sur la surface à usiner de la pièce (31), sur une aire (41, 51) d'un mm² jusqu'à un cm², avec une distribution de la puissance sensiblement homogène ;
exécuter un mouvement relatif entre la pièce (31) et le faisceau d'usinage de telle sorte ce que chaque unité d'aire à enlever de la pièce (31) est exposée à une quantité d'énergie sensiblement constante.

2. Procédé selon la revendication 1, dans lequel les impulsions sont produites par une modulation de la puissance d'excitation.

3. Procédé selon la revendication 1, dans lequel les impulsions lumineuses sont produites par la méthode de la modulation de qualité.

4. Procédé selon l'une des revendications 1 à 3, dans lequel les impulsions lumineuses présente une durée d'impulsion dans la plage de 25 ns.

5. Procédé selon l'une des revendications 1 à 4, dans lequel la vitesse d'avance du mouvement relatif et la fréquence de répétition des impulsions lumineuses sont harmonisées entre elles de manière qu'une unité d'aire ne soit plus exposée au faisceau d'usinage dès que la couche à enlever est éliminée.

6. Procédé selon la revendication 5, dans lequel le premier dispositif de positionnement est déplacé avec une vitesse d'avance de l'ordre de 1 cm/s et la fréquence des séquences d'impulsions du résonateur laser est de l'ordre de 50 Hz.

7. Procédé selon l'une des revendications 5 ou 6, dans lequel une unité d'aire est exposée essentiellement à une seule impulsion lumineuse ou à très peu d'impulsions lumineuses.

8. Procédé selon l'une des revendications 1 à 7, dans lequel la longueur d'onde du résonateur laser est harmonisée avec la couche à enlever de manière que les impulsions lumineuses soient essentiellement absorbées par la couche à enlever et ne soient pas absorbées par le matériau de support.

9. Procédé selon la revendication 8, dans lequel le résonateur laser est du type Nd:YAG avec une longueur d'onde de 1 064 µm.

10. Procédé selon l'une des revendications 1 à 9, dans lequel on règle un angle d'usinage constant entre l'axe optique du faisceau d'usinage et la perpendiculaire (43, 53) à chaque unité d'aire à enlever.

11. Procédé selon l'une des revendications 1 à 10, dans lequel on encapsule un module solaire à couches minces composé d'un substrat revêtu de couches minces, le substrat étant d'abord décapé dans les régions marginales à l'aide d'un procédé selon l'une des revendications 1 à 10 et le substrat total étant ensuite revêtu sur le côté des couches minces par une couche laminée de telle manière que les couches minces soient encapsulées par le substrat et la couche laminée.
